## Europäisches Patentamt

## European Patent Office

## Office européen des brevets

(19)

(11) Veröffentlichungsnummer: **0 140 082**
**B1**

(12) **EUROPÄISCHE PATENTSCHRIFT**

(45) Veröffentlichungstag der Patentschrift:
**16.08.89**

(51) Int. Cl.⁴: **H 03 K 9/08**

(21) Anmeldenummer: **84110808.7**

(22) Anmeldetag: **11.09.84**

(54) Elektronische Schaltungsanordnung zur Umwandlung der Dauer eines Pulses in eine proportionale Spannung.

(30) Priorität: **05.10.83 DE 3336170**
**19.10.83 DE 3341826**

(43) Veröffentlichungstag der Anmeldung:
**08.05.85 Patentblatt 85/19**

(45) Bekanntmachung des Hinweises auf die Patenterteilung:
**16.08.89 Patentblatt 89/33**

(84) Benannte Vertragsstaaten:
**DE FR SE**

(56) Entgegenhaltungen:
**DE-A- 3 026 097**
**FR-A- 2 512 952**
**GB-A- 2 053 351**
**US-A- 3 617 760**
**US-A- 3 646 460**
**US-A- 3 991 323**
**US-A- 4 125 023**
**US-A- 4 292 841**

**IEEE TRANSACTIONS ON NUCLEAR SCIENCE, Band NS-29, Nr. 1, Februar 1982, Seiten 299-302, IEEE, New York, US; T.F. DROEGE et al.: "A high reliability, high resolution drift chamber readout system for the colliding beam facility at fermilab"**

(73) Patentinhaber: **ROBERT BOSCH GMBH, Postfach 50, D-7000 Stuttgart 1 (DE)**

(72) Erfinder: **Dreyer, Adolf, Dipl.-Ing.,**
**Theodor-Heuss-Strasse 12, D-7141 Oberriexingen (DE)**
Erfinder: **Gorille, Ingo, Dr., Ahornweg 11,**
**D-7141 Oberriexingen (DE)**
Erfinder: **Nitschke, Werner, Dipl.-Phys.,**
**Roseggerweg 14, D-7257 Ditzingen (DE)**
Erfinder: **Renk, Ralph, Dipl.-Ing., Torfstrasse 9,**
**D-7250 Leonberg (DE)**
Erfinder: **Roozenbeek, Herman, Breslauer Strasse 51,**
**D-7141 Schwieberdingen (DE)**

ACTORUM AG

## Beschreibung

### Stand der Technik

Die Erfindung geht aus von einer elektronischen Schaltungsanordnung nach der Gattung des Hauptanspruchs.

Bekannt ist aus der US-PS 4 292 481 ein «Compression Rate Analyzer», bei dem nach Figur 6 das Ausgangssignal eines Sensors über einen Schwellwertschalter einem Kondensator zugeführt wird, die Kondensatorspannung nach einer Analog/Digital-Wandlung in einem Prozessor verarbeitbar ist, der auch das Reinitialisieren des bzw. der Kondensatoren steuert. Das Ladesignal für die einzelnen Kondensatoren entstammt einem Operationsverstärker 198a, dem wiederum das mittels eines Spannungsteilers heruntergeteilte Ausgangssignal des Sensors zuführbar ist.

Mit dieser Schaltungsanordnung ergeben sich keine optimalen Verhältnisse bezüglich des Ladesignals für die einzelnen Kondensatoren, weil Rückwirkungen auf das erfaßte Signal nicht auszuschließen sind. Darüber hinaus haftet der bekannten Lösung der Mangel einer sehr starken Spannungsempfindlichkeit an.

Ferner ist aus der US-PS 3 646 460 ein Digital/Analog-Wandler bekannt, bei dem nach Figur 2 ein Kondensator über einen in Kollektorschaltung betriebenen Transistor aufladbar ist. Der Emitter des Transistors ist seinerseits unmittelbar an einer Versorgungsspannungsleitung angeschlossen. Auch hier ergibt sich demnach das Problem einer Spannungsabhängigkeit im Ausgangssignal des Wandlers.

Die elektronische Erfassung einer Pulsdauer und deren Umwandlung in eine proportionale Spannung ist auch schon von den Verfahren zur Demodulation von pulsdauermodulierten Signalen (PDM) bekannt, wie sie im «Handbuch für Hochfrequenz- und Elektro-Techniken», Band 1/1978 Kapitel 3.4, von Rint, und in «Pulstechnik», Band I/1975, Seite 277 bis 280, von Hölzler und Holzwarth, beschrieben sind. Bei diesen Verfahren wird durch den Puls ein Sägezahngenerator ein- und ausgeschaltet, so daß bei Pulsende die erreichte Spannung des Sägezahngenerators proportional zur Pulsdauer ist. Ebenfalls wird in digitalen Systemen das äquivalente Verfahren der Auszählung der Pulsdauer verwendet. Ein Nachteil dieses Verfahrens ist, daß hierfür eine Vielzahl verschiedener Gatter, Zähler und Latches erfoderlich sind, da die Übergabe des Zählergebnisses in den meisten Fällen synchron mit dem Takt eines Mikrocomputers auf dessen Data-Bus erfolgt.

Es ist weiterhin von Nachteil, daß bei Auszählung der Pulsdauer durch einen Mikrocomputer dieser während der Auszählung so beschäftigt ist, daß er für weitere Aufgaben nicht zur Verfügung steht.

Aus dem Bereich der Klopfregelung für Brennkraftmaschinen, wie sie aus der US-PS 4 110 035 und der DE-OS 3 026 097 bekannt sind, ist ebenfalls die Verwendung einer Pulsdauer als Informationsträger – Stellgröße für einen Regelkreis –

bekannt. Auch hier wird die Pulsdauer durch Auszählung digital ermittelt. Im durch die Zündanlage elektromagnetisch stark gestörten Bereich in der Nähe von laufenden Brennkraftmaschinen ist die Wahrscheinlichkeit des Auftretens von kurzzeitigen Störimpulsen sehr groß. Das macht es notwendig, für besondere Sicherheitsmaßnahmen zu sorgen, damit von der digitalen Zählelektronik das Auftreten von solchen Störimpulsen nicht als das Ende des zu messenden Pulses interpretiert wird, und es zu einer fehlerhaften Messung kommt.

Eine Pulsdauer als Informationsträger wird ebenfalls bei elektronischen Einspritzgeräten für die Lastinformation verwendet. Hierbei ist die Dauer eines Pulses eine Funktion des Druckes im Ansaugrohr der Brennkraftmaschine. Auch dabei gelten die vorhergehenden Nachteile.

### Vorteile der Erfindung

Die erfindungsgemäße Schaltungsanordnung mit den kennzeichnenden Merkmalen des Hauptanspruches hat den Vorteil, daß es durch die Integration eines Stromes während der Dauer des Pulses unabhängig vom Zustand des Mikrocomputers möglich wird, eine zur Pulsdauer proportionale Spannung bereitzuhalten.

Besonders vorteilhaft ist es, daß es durch die Integration des Ausgangsstromes einer spannungsgesteuerten Stromquelle möglich wird, mit geringem Aufwand im Integranten eine Funktion, nämlich die Steuerfunktion der Stromquelle hinzu zu multiplizieren.

Durch die Ausführung der Erfindung in Analog-Technik ist die Anfälligkeit der Messung gegenüber kurzen Störimpulsen sehr gering, d. h. die Störimpulse wirken sich nur mit ihrer proportionalen Dauer, bezogen auf die Dauer des zu messenden Pulses, aus. Von weiterem Vorteil ist die einfachere Realisierung im Hinblick auf Anzahl der Bauelemente und damit der Kosten, wie sie im Vergleich mit einer möglichen Realisierung in Digital-Technik kaum erreicht werden könnte. Des weiteren ist die analoge Realisierung nicht von einem Takt abhängig.

Ferner ist als Vorteil zu nennen, daß aufgrund der Maßnahme die Steuerspannung der spannungsgesteuerten Stromquelle und die Referenzspannung des Analog-Digital-Wandlers proportional zu einer Versorgungsspannung zu wählen, das Analog-Digital-Wandlungsergebnis zum reinen Quotienten wird, der unabhängig von dieser Versorgungsspannung ist.

### Zeichnung

Ein Ausführungsbeispiel der Erfindung ist in der Zeichnung dargestellt und in der nachfolgenden Beschreibung näher erläutert. Figur 1 zeigt einen Ausschnitt aus einer Klopfregelung für Brennkraftmaschinen und Figur 2 eine verbesserte Version einer Entladungsschaltung. Figur 3 zeigt eine vereinfachte Version eines Pulsdauer-Spannungs-Wandlers.

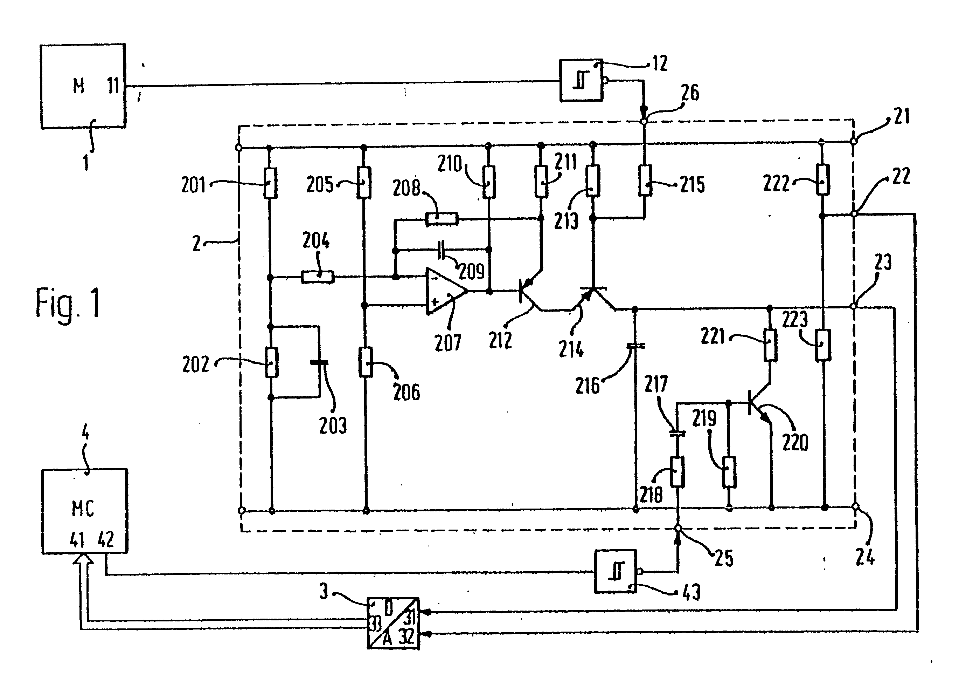

### Beschreibung des Ausführungsbeispieles Die Figur 1 zeigt eine Motorelektronik 1, einen Pulsdauer-Spannungs-Wandler (PSW) 2, einen Analog/Digital (A/D)-Wandler 3 und einen Mikrocomputer (MC) 4. Alle diese Baugruppen sind untereinander zur Potentialfestlegung mit einer nicht dargestellten Masseleitung verbunden, die an einer Klemme 24 des PSW 2 liegt.

Ein Ausgang 11 der Motorelektronik 1 ist mit dem Eingang eines Triggerinverters 12 verbunden, dessen Ausgang an einer Klemme 26 des PSW 2 liegt. Eine Klemme 22 des PSW 2 ist mit einem Eingang 32 des A/D-Wandlers 3 verbunden, eine Klemme 23 ist mit einem Eingang 31 des A/D-Wandlers verbunden. Der Datenausgang 33 des A/D-Wandlers 3 ist mit einem Dateneingang 41 des MC 4 verbunden. Ein Ausgang 42 des MC 4 ist mit dem Eingang eines Triggerinverters 43 verbunden, dessen Ausgang an einer Klemme 25 des PSW 2 liegt.

An einer Klemme 21 des PSW 2 liegt eine nicht dargestellte Versorgungsspannung U21. An der Klemme 21 Widerstände 201, 205, 210, 211, 213, 222 angeschlossen. Auf der anderen Seite sind diese Widerstände verbunden: Der Widerstand 201 mit einem Widerstand 204 und einem Widerstand 202, der Widerstand 205 mit einem Widerstand 206, der Widerstand 210 mit dem Ausgang eines Operationsverstärkers (OP) 207, der Widerstand 211 mit dem Emitter eines Transistors 212, der Widerstand 213 mit der Basis eines Transistors 214, der Widerstand 222 mit einem Widerstand 223. Die Widerstände 202, 206, 223 liegen ihrerseits an der Klemme 24. Parallel zum Widerstand 202 ist eine Kapazität 203 geschaltet. Der invertierende Eingang des OP 207 ist über einen Widerstand 204 mit dem Verbindungspunkt der Widerstände 201 und 202 verbunden. Der nicht invertierende Eingang des OP 207 ist mit dem Verbindungspunkt der Widerstände 206, 205 verbunden. Die Klemme 22 ist mit dem Verbindungspunkt der Widerstände 222, 223 verbunden. Zwischen dem invertierenden Eingang und dem Ausgang des OP 207 liegt eine Kapazität 209, zwischen dem invertierenden Eingang des OP 207 und dem Emitter des Transistors 212 liegt ein Widerstand 208. Der Ausgang des OP 207 führt an die Basis des Transistors 212, dessen Kollektor am Emitter des Transistors 214 liegt. Zwischen der Basis des Transistors 214 und dem Widerstand 213 führt ein Widerstand 215 an die Klemme 26. Der Kollektor des Transistors 214 liegt an der Klemme 23. Eine Kapazität 216 ist zwischen die Klemme 23 und die Klemme 24 geschaltet. Von der Klemme 23 führt ein Widerstand 221 zum Kollektor eines Transistors 220, dessen Emitter an der Klemme 24 liegt. Die Basis des Transistors 220 liegt über einen Widerstand 219 an der Klemme 24, sowie über eine Kapazität 217 und einen Widerstand 218 an der Klemme 25.

Im PSW 2 bilden die Bauteile 201 bis 212 eine spannungsgesteuerte Stromquelle, die Bauteile 213 bis 215 bilden einen Schalter, die Kapazität 216 ist ein Integrierer, die Bauteile 217 bis 221 bilden eine Entladeschaltung.

Der Ausgangsstrom der spannungsgesteuerten Stromquelle ist der Emitter-Kollektor-Strom des Transistors 212. Dieser Ausgangsstrom ist gleich dem Strom durch den Widerstand 211 abzüglich dem Strom durch den Widerstand 208 zum invertierenden Eingang des OP 207 und durch den Widerstand 204 und den Widerstand 202 zur Klemme 24. Das Potential des invertierenden Eingangs des OP 207 ist (unter Vernachlässigung der Offset-Eingangsspannung) gleich dem Potential U206 am nicht invertierenden Eingang, das durch das Spannungsteilerverhältnis der Widerstände 206 und 205 festgelegt ist. Durch das konstante Potential U21 am Widerstand 201 und das konstante Potential des invertierenden Eingangs des OP 207 am Widerstand 204 ist der Strom durch den Widerstand 204 eindeutig festgelegt. Dieser Strom ist gleich dem Strom durch den Widerstand 208. Damit fällt am Widerstand 208 eine konstante Spannung U208 ab. Der Spannungsabfall am Widerstand 211 ist also konstant und gleich der Spannung U21 abzüglich der Spannungen U208 und U206. Damit ist der Ausgangsstrom unabhängig von der Basis-Emitter-Spannung des Transistors 212 und gleich dem Spannungsabfall am Widerstand 211 dividiert durch dessen Widerstandswert.

In der in diesem Ausführungsbeispiel gewählten Schaltungsanordnung für die spannungsgesteuerte Stromquelle ist der Ausgangsstrom gleich U21 multipliziert mit einer Konstanten die abhängig ist von den Werten der Widerstände 201, 202, 204, 205, 206, 208, 211. Die Kapazitäten 203, 209 und der Widerstand 210 dienen zur Verbesserung des Einschwingverhaltens. Da der Basisstrom des Transistors 212 in den OP 207 hineinfließt, ist der Einfluß der Temperaturdrift der Basis-Emitter-Spannung des Transistors 212 auf den Ausgangsstrom hiermit eliminiert. Als beeinflussende Größen kommen nur noch die sehr geringen Temperaturdrifte der Werte des OP 207 hinzu. Durch die Spannung am nicht invertierenden Eingang des OP 207, also der Teilerspannung der Widerstände 205 und 206, läß sich der Ausgangsstrom in weitem Bereich steuern, beispielsweise durch wahlweises Hinzuschalten von Parallelwiderständen zu Widerstand 205 oder 206.

Die Stromquelle ist mit einer Brückenschaltung versehen, die aus den Widerständen 204, 208, 206, 205 besteht. Durch diese Anordnung wird erreicht, daß die steuernde Spannung U206 und die Ausgangsspannung des PSW 2 an der Klemme 23 auf gleichem Bezugspotential liegen. Die Spannung U206 kann aus einem Referenzelement, das gegen die Klemme 24 geschaltet ist, oder wie im gewählten Ausführungsbeispiel aus Teilung der Spannung U21 gewonnen werden. Mit letzterem ist sichergestellt, daß der Ausgangsstrom sich mit der Spannung U21 proportional ändert. Von weiterem Vorteil ist, daß durch die Brückenschaltung der OP 207 nicht an der Grenze seines Gleichtakt-Aussteuerungs-Bereiches betrieben wird.

Beim Schalter sind die Widerstände 213 und 215 so dimensioniert, daß bei einer Spannung von angenähert 0 Volt die Emitter-Kollektor-Strecke des Transistors 214 niederohmig ist, bei angenähert 5 Volt (TTL-Pegel) die Emitter-Kollektor-Strecke des Transistors 214 hochohmig ist.

Beim Auftreten einer positiven Signalflanke an der Klemme 25 wird über den RC-Hochpaß 218, 217 die Basis des Transistors 220 für eine Zeitdauer in der Größenordnung der Zeitkonstanten des RC-Hochpasses auf über etwa 0,7 Volt gezogen, so daß innerhalb dieser Zeitdauer die Kapazität 216 über den Widerstand 221 und die Kollektor-Emitter-Strecke des Transistors 220 entladen wird. Außerhalb dieser Zeitdauer ist die Basis des Transistors 220 durch den Widerstand 219 an Masse gelegt, der Transistor 220 ist also hochohmig.

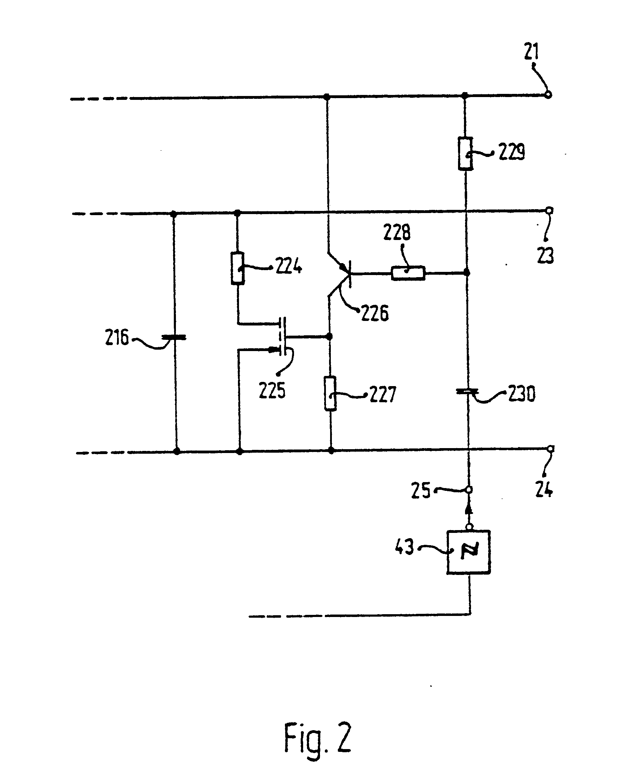

Eine verbesserte Version einer möglichen Entladeschaltung unter Verwendung eines VMOS-Feldeffekttransistors 225 zeigt Figur 2. Zur Vereinfachung der Darstellung ist nur der schaltungstechnische Einbau im PSW an Stelle der bisherigen Bauelemente 217 bis 221 gezeigt.

Der Drain-Anschluß des Transistors 225 liegt über einen Widerstand 224 an der Klemme 23 und der Source-Anschluß an der Klemme 24. Der Gate-Anschluß ist über einen Widerstand 227 mit der Klemme 24 und mit dem Kollektor eines pnp-Transistors 226 verbunden, dessen Emitter an der Klemme 21 liegt. Die Basis des Transistors 226 ist über einen Widerstand 228 mit dem Verbindungspunkt eines Widerstandes 229 und einer Kapazität 230 verbunden. Ihrerseits liegen der Widerstand 229 an der Klemme 21 und die Kapazität 230 an der Klemme 25.

Eine negative Signalflanke an der Klemme 25 läßt den Transistor 226 niederohmig werden, damit verschiebt sich das Potential am Gate des Transistors 225 für eine Zeitdauer in der Größenordnung der Zeitkonstanten der Kapazität 230 und des Widerstandes 229 zu positiven Werten hin, so daß die Kapazität 216 über den Widerstand 224 und die Drain-Source-Strecke des Transistors 225 entladen wird. Von Vorteil sind bei dieser Version der Entladeschaltung die besseren Schalteigenschaften, vor allem bessere Tiefentladung der Kapazität 216 und das günstigere Temperaturverhalten, durch die Verwendung des Feldeffekttransistors 225.

In der Motorelektronik 1 werden Informationen über den Lastzustand des Motors, insbesondere für den Einsatz einer Klopfregelung, in kodierter Form über die Dauer von Pulsen am Ausgang 11 übertragen. Die empfangenen Pulse werden durch den Triggerinverter 12 regeneriert und an die Klemme 26 des PSW 2 gelegt. Während der Dauer dieser Pulse ist der Transistor 214 geöffnet und die Kapazität 216 integriert den Ausgangsstrom der spannungsgesteuerten Stromquelle. Am Ende eines Pulses wird der Transistor 214 geschlossen. Die Spannung der Kapazität 216 wird über die Klemme 23 an den A/D-Wandler 3 geleitet.

Durch Ausnutzung der Spannungssteuerungsfähigkeit der Stromquelle, beispielsweise durch wahlweises Hinzuschalten von Parallelwiderständen zu Widerstand 205 oder 206 läßt sich dem Meßergebnis eine Steuerfunktion aufprägen, bzw. gewisse Meßzeiten ausblenden, oder ähnliches.

Der Zeitpunkt des Datenempfangs für den MC 4 ist durch das Speicherverhalten der Kapazität 216 unabhängig vom Ende der Integration bzw. vom Ende der Pulsdauer. Es treten also keine Synchronisationsprobleme auf, da das Integrationsergebnis lange Zeit als Spannung an der Kapazität 216 anliegt, und erst nach Erhalt des Quittungssignales an der Klemme 25 gelöscht wird.

Die in diesem Ausführungsbeispiel angegebene Schaltungsanordnung eignet sich selbstverständlich nicht nur für den Einsatz in Klopfregelungen, sondern kann darüber hinaus auch Anwendungen finden für Zeitmessungen allgemeiner Art, wie beispielsweise der Schließdauer von Unterbrecherkontakten, oder zur Einhaltung gewisser vorgegebener Zeitgrenzen.

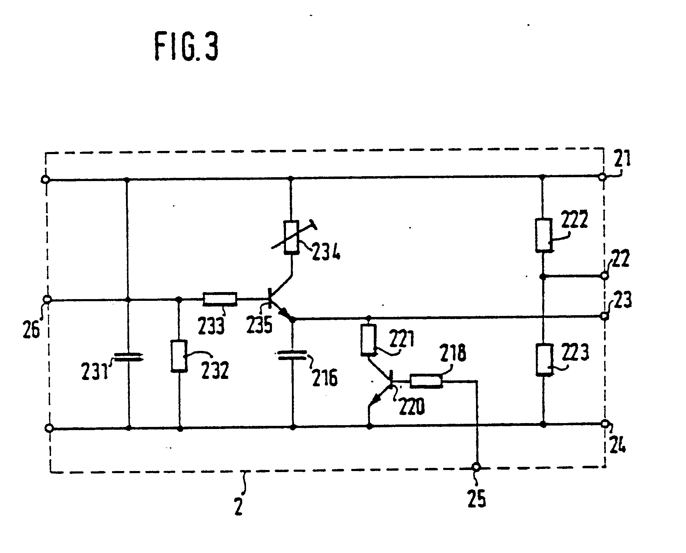

In Figur 3 ist eine vereinfachte Version eines PSW 2 mit Anschlußklemmen 21 bis 26 dargestellt. Der PSW 2 nach Figur 3 entspricht dabei der Funktion des PSW 2 nach Figur 11. In beiden Versionen sind dabei die Anschlußklemmen gleich bezeichnet. Ebenso sind in beiden Versionen die Kapazität 216 des Integrierers und der Spannungsteiler 222, 223 gleich bezeichnet. Eine vereinfachte Entladeschaltung bestehend aus den Widerständen 218, 221 und dem Transistor 220 der Funktion der Entladeschaltung nach Figur 1 mit den gleich bezeichneten Bauteilen. Zur Vereinfachung der Darstellung sind die gleichbleibenden Anschlüsse zu und vom MC4, A/D-Wandler 3 und Motorelektronik 1 nicht dargestellt.

Zwischen die Klemmen 24 und 26 ist ein Widerstand 232 und parallel zu ihm eine Kapazität 231 geschaltet. Von der Klemme 26 führt ein Widerstand 233 an die Basis eines Transistors 235. Der Kollektor des Transistors 235 führt über einen abgleichbaren Widerstand 234 an die Klemme 21. Der Emitter des Transistors 235 ist an die Klemme 23 und über die Kapazität 216 an die Klemme 24 gelegt. Der Widerstand 218 führt von der Klemme 25 an die Basis des Transistors 220, dessen Emitter an der Klemme 24 liegt. Der Kollektor des Transistors 220 führt über den Widerstand 221 an die Klemme 23.

Beim Auftreten einer positiven Spannung an der Klemme 26 wird der Transistor 235 leitend und über den Widerstand 234 lädt sich die Kapazität 216 nach einer e-Funktion auf. Liegt bei Beendigung des Pulses an der Klemme 26 wieder ein niedriges Potential an, so ist die Kollektor-Emitter-Strecke des Transistors 235 hochohmig und die Spannung an der Kapazität 216 bleibt erhalten. Ist der an die Klemme 26 angeschlossene Triggerinverter 12 in einem hochohmigen Zustand, so wird die Basis des Transistors 235 über die Widerstände 232, 233 an die Klemme 24 gelegt und somit der Transistor 235 geschlossen. Die kleine Kapazität 231 und der Widerstand 232 dienen zur Verbesserung des Einspringverhaltens. Die durch die Integration des Stromes an der Kapazität 216 erreichte Spannung bleibt erhalten, bis durch einen positiven Impuls an der Klemme 25 die Kapazität 216 über den Widerstand 221 und den Transistor 220 gelöscht wird.

Der hauptsächliche Unterschied zwischen dem PSW2 nach Figur 1 und Figur 3 besteht darin, daß in dem PSW2 nach Figur 2 an der Kapazität 216 die integrierte Spannung nach einer e-Funktion ansteigt. Diese logarithmische Verzerrung des Meßergebnisses läßt sich aber leicht durch eine entsprechende Korrektur im Verarbeitungsprogramm des MC4 erreichen. Durch den abgleichbaren Widerstand 234 läßt sich eine optimale Genauigkeit im bevorzugten Aussteuerungsbereich einstellen.

Die Referenzspannung des A/D-Wandlers wird über einen Spannungsteiler 222, 223 aus der Versorgungsspannung U21 des PSW 2 gebildet. Damit ist sowohl das Integrationsergebnis wie die Referenzspannung proportional zu U21. Das A/D-Wandlungsergebnis ist damit unabhängig von U21, da es sich aus einer Konstanten mal der Eingangsspannung dividiert durch die Referenzspannung ergibt. U21 kürzt sich also heraus. Das Wandlungsergebnis wird über den Datenausgang 33 an den Dateneingang 41 des MC 4 gegeben. Nach Empfang des Wandlungsergebnisses gibt der MC 4 über seinen Ausgang 42 ein Quittungssignal an die Klemme 25 des PSW 2 ab. Dieses Quittungssignal bewirkt eine Entladung der Kapazität 216 über den Transistor 220 und dem Widerstand 221. Somit ist der PSW 2 zum Empfang eines neuen Pulses mit veränderter Dauer reinitialisiert.

## Patentansprüche

1. Elektronische Schaltungsanordnung zur Umwandlung eines Pulses in eine dessen Dauer proportionale Spannung, mit einem Integrierer (216), dem während der Dauer des Pulses ein Ladesignal zugeführt und dessen Ausgangssignal nach Analog-Digital-Wandlung in einem Mikrocomputer (4) verarbeitet wird, mit Mitteln (218 bis 221) zur Reinitialisierung des Integrierers abhängig von einem Ausgangssignal des Mikrocomputers (4), sowie einer Schalteinrichtung (213 bis 215) für das Ladesignal des Integrierers (216), dadurch gekennzeichnet, daß das Ladesignal der Ausgangsstrom einer spannungsgesteuerten Stromquelle (201 bis 212) ist und die Steuerspannung der Stromquelle und die Referenzspannung des Analog-Digital-Wandlers (3) proportional zu einer Versorgungsspannung der Stromquelle sind, so daß das Analog-Digital-Wandlungsergebnis unabhängig von der Versorgungsspannung ist.

2. Elektronische Schaltungsanordnung nach Anspruch 1, dadurch gekennzeichnet, daß die Steuerspannung der Stromquelle und die Ausgangsspannung des Integrierers (216) auf gleichem Bezugspotential liegen.

## Claims

1. Electronic circuit for converting a pulse into a voltage proportional to its width, comprising an integrator (216) which is supplied with a charging signal for the width of the pulse and the output signal of which, after analog/digital conversion, is processed in a microcomputer (4), with means (218 to 221) for reinitializing the integrator in dependence on an output signal of the microcomputer (4), and a switching device (213 to 215) for the charging signal of the integrator (216), characterized in that the charging signal is the output current of a voltage-controlled current source (201 to 212) and the control voltage of the current source and the reference voltage of the analog/digital converter (3) are proportional to a supply voltage of the current source so that the result of the analog/digital conversion is independent of the supply voltage.

2. Electronic circuit according to Claim 1, characterized in that the control voltage of the current source and the output voltage of the integrator (216) are at the same reference potential.

## Revendications

1. Circuit électronique assurant la conversion d'une impulsion en une tension proportionnelle à la durée de cette impulsion, avec un intégrateur (216), auquel est appliqué, pendant la durée de l'impulsion, un signal de charge, et dont le signal de sortie après conversion analogique-numérique est traité dans un microcalculateur (4), avec des moyens (218 à 221) permettant la re-initialisation de l'intégrateur en fonction d'un signal de sortie du microcalculateur (4), ainsi qu'avec un dispositif de commutation (213 à 215) pour le signal de charge de l'intégrateur (216), circuit électronique caractérisé en ce que le signal de charge est le courant de sortie d'une source de courant (201 à 212) commandée en tension, et la tension de commande de cette source de courant et la tension de référence du convertisseur analogique-numérique (3) étant proportionnelle à une tension d'alimentation de la source de courant, de sorte que le résultat de la conversion analogique-numérique est indépendant de la tension d'alimentation.

2. Circuit électronique selon la revendication 1, caractérisé en ce que la tension de commande de la source de courant et la tension de sortie de l'intégrateur (216) se situent au même potentiel de référence.

Fig. 1

EP 0 140 082 B1

Fig. 2

# FIG.3